(19) **Europäisches Patentamt / European Patent Office / Office européen des brevets**

(11) **EP 1 913 693 B1**

(12) **FASCICULE DE BREVET EUROPEEN**

(45) Date de publication et mention
de la délivrance du brevet:
**02.12.2009 Bulletin 2009/49**

(21) Numéro de dépôt: **06777555.1**

(22) Date de dépôt: **03.07.2006**

(51) Int Cl.:
***H03K 3/84*** (2006.01)

(86) Numéro de dépôt international:
**PCT/EP2006/063809**

(87) Numéro de publication internationale:
**WO 2007/012544 (01.02.2007 Gazette 2007/05)**

(54) **PROCEDE ET DISPOSITIF DE BRUITAGE**

GERÄUSCHERZEUGUNGSEINRICHTUNG UND -VERFAHREN

NOISE-GENERATING DEVICE AND METHOD

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **29.07.2005 FR 0508130**

(43) Date de publication de la demande:
**23.04.2008 Bulletin 2008/17**

(73) Titulaire: **THALES**
**92200 Neuilly sur Seine (FR)**

(72) Inventeurs:
• **JOSSO, Bruno**
  **F-06160 Juan les Pins (FR)**

• **BILLET, Daniel**
  **F-06140 Tourette s/Loup (FR)**

(74) Mandataire: **Lucas, Laurent Jacques**
**Marks & Clerk France**
**Conseils en Propriété Industrielle**
**Immeuble " Visium "**
**22, avenue Aristide Briand**
**94117 Arcueil Cedex (FR)**

(56) Documents cités:
**US-A- 4 173 000    US-A- 4 375 620**
**US-B1- 6 560 212**

EP 1 913 693 B1

**Description**

**DOMAINE DE L'INVENTION**

La présente invention concerne le domaine de la génération de signaux sous contraintes et plus précisément la production de signaux discrétisés à spectre imposé par exemple pour réaliser des bruiteurs ou des brouilleurs. L'invention concerne en particulier le domaine des bruiteurs acoustiques.

**CONTEXTE DE L'INVENTION - ART ANTERIEUR**

Les qualités qui sont demandées aux brouilleurs en particulier aux brouilleurs acoustiques sont; sous un volume et un poids contrôlés, d'émettre un bruit de densité spectrale de puissance (d.s.p.) imposée avec une autonomie énergétique la plus grande possible.

Il est connu dans l'art antérieur de procéder en associant à un pilote chargé de synthétiser le signal à émettre, un amplificateur de puissance qui fournit l'excitation électrique en même temps qu'il réalise l'adaptation à l'impédance électrique du transducteur lequel transforme le signal électrique en signal électromagnétique, optique, acoustique, etc... suivant le milieu dans lequel s'effectue le brouillage ou le bruitage.

La classe de l'amplificateur de puissance utilisé (A, AB, B, C, D, E, F,...) dépend des contraintes de linéarité, rendement, fréquence maximale, résolution, etc.. imposées opérationnellement.

L'utilisation de moyens conventionnels pose dans certains cas de sérieux problèmes. Les transducteurs ont des impédances complexes ou réactives dépendant de la fréquence qui impliquent de mettre en oeuvre après amplification des adaptateurs eux même réactifs inductif ou capacitifs associés éventuellement à des transformateurs magnétiques. Ces éléments ont généralement un encombrement et un poids qui rendent leur usage rédhibitoire. De même, dans certaines applications particulières, la réalisation d'amplificateurs linéaires de grande puissance, de grande dynamique et large bande n'est pas toujours compatible avec les conditions de rendement, de poids et de volume, imposées par certaines applications.

Pour répondre aux contraintes de rendement et de miniaturisation des amplificateurs linéaires de puissance il est possible de réaliser un signal électrique de forte amplitude en mettant en série un certain nombre de sources de tensions continues de tailles raisonnables et délivrant des tensions de valeurs adéquates. Chaque source délivre, par l'intermédiaire d'un système de commutation approprié, une tension généralement constante au circuit série ainsi réalisé. De la sorte, sous l'action d'une commande propre, variable dans le temps, appliquée au commutateur correspondant, chaque source est mise en série avec d'autres sources elles aussi sélectionnées et la tension V produite par cette source vient s'ajouter aux tensions produites par les autres sources de façon à produire le niveau voulu.

Dans une réalisation simple, on peut, décrit par exemple dans US 4,173,000, utiliser une seule source de tension dont les sorties peuvent être commutées de façon à générer un signal se présentant sous la forme d'une séquence codée à deux niveaux, ayant la puissance nécessaire pour exciter un transducteur. Les commutations peuvent par exemple être commandées selon une séquence binaire de longueur maximale, répétée pour produire un bruit blanc. Cette solution est très satisfaisante sur le plan énergétique mais ne permet pas la prise en compte des contraintes spectrales qui sont la plupart du temps imposées dans les bruiteurs surtout lorsqu'ils ont vocation de leurrer.

Une façon de procéder est de partir d'un signal analogique, synthétisé par un pilote ayant les caractéristiques désirées, et de procéder à la sélection des sources en discrétisant le signal du pilote par autant de niveaux qu'il est nécessaire pour calculer les indicatrices de basculement des sources. Le signal produit obtenu est appliqué au transducteur, il a la puissance désirée mais il est discrétisé et n'a donc plus exactement la même d.s.p. que le signal continu. Les limitations de ce procédé, sont multiples. Pour ne pas dénaturer la d.s.p. du signal du fait de la discrétisation on a tendance à multiplier le nombre de niveaux c'est à dire à augmenter le nombre des sources de tension et donc le poids et l'encombrement. Cela conduit aussi à une augmentation de la fréquence des transitions de niveau qui conduit à une baisse du rendement.

Des méthodes autres que cette discrétisation directe sont possibles. Une solution consiste à mettre en oeuvre une méthode de synthèse connue, de type "conversion à faible nombre de bit de quantification (jusqu'à 1)" comme la modulation "Sigma-Delta" par exemple. Cette solution non développée ici est cependant rarement utilisée pour générer un bruit ayant un spectre déterminé. Par principe ce type de synthèse résout le problème de dynamique posé. En revanche, il favorise, par la conformation spectrale du bruit de quantification intrinsèque à son fonctionnement suréchantillonné le déplacement de l'énergie du bruit de quantification vers les parties hautes du spectre. Un filtrage important de ce bruit hors de la bande utile est généralement nécessaire, ce qui réduit radicalement l'intérêt de cette approche. Un moyen de limiter ces effets consiste alors à augmenter de manière forte la fréquence d'échantillonnage du système, moyen qui pour des raisons matérielles technologiques ou de coût n'est pas toujours utilisable.

Un autre moyen de réaliser la synthèse du signal de commande consiste à utiliser une méthode de synthèse basée sur le principe connu de la modulation de la largeur d'impulsion ou "Pulse Width Modulation" selon la dénomination anglo-saxonne. Dans cette méthode les instants de transition sont définis par l'amplitude du signal. La génération de bruit hors bande est limitée et la précision du codage est satisfaisante. En revanche cette méthode de synthèse implique de disposer d'une horloge variable et reste donc une solution relativement difficile à mettre en oeuvre et par ailleurs coûteuse. On peut synchroniser les transitions mais il faut choisir, pour l'horloge, une fréquence beaucoup plus élevée que la fréquence de Shannon : on retombe sur des problèmes similaires à ceux décrits précédemment.

## PRESENTATION DE L'INVENTION

Un but de l'invention est de réaliser un émetteur de bruit de d.s.p. imposée, qui soit léger et compact et de haut rendement. Dans cette perspective une optimisation conjointe des trois étapes : synthèse du signal, production de la puissance et transduction, est recherchée.

A cet effet l'invention a pour objet un dispositif pour rémission d'un bruit discrétisé sur au moins deux niveaux, comportant au moins:

- un synthétiseur permettant de produire un bruit numérique échantillonné et quantifié,
- un transducteur relié à un circuit d'alimentation,
- des sources d'alimentation électrique,
- des commutateurs pour intégrer séparément chaque source au circuit d'alimentation, les sources intégrées au circuit d'alimentation étant mises en série les unes avec les autres,
- des moyens de commande permettant de générer le signal de commande de chaque commutateur.

Le dispositif selon l'invention présente les caractéristiques suivantes:

- les moyens de synthèse produisent, par synthèse numérique itérative sous contrainte de spectre, un bruit quantifié sur au moins deux niveaux et ayant une densité spectrale de puissance déterminée,
- le signal de commande appliqué à chaque commutateur est généré par les moyens de commande en fonction du bruit produit par le synthétiseur, le signal de commande étant synchrone de l'horloge de base du synthétiseur,
- un certain nombre de sources sont mises en série, à un instant t, aux bornes du transducteur pour fournir une tension à l'image de la valeur à cet instant du bruit numérique produit par le synthétiseur.

Selon une caractéristique du dispositif selon l'invention, pour chaque valeur de tension à appliquer au transducteur, les moyens de commande produisent un signal de commande qui est fonction de la valeur du bruit produit par le synthétiseur et des caractéristiques de chacune des sources disponibles.

Selon une forme particulière de réalisation, le dispositif d'émission selon l'invention comporte L sources identiques et des moyens de commandes adaptés pour gérer la mise en service des sources en fonction de la tension à appliquer à l'instant considéré et de leur état de charge ou de réserve énergétique afin d'optimiser l'autonomie de l'ensemble.

Selon une forme particulière de réalisation le dispositif selon l'invention comporte au moins:

- un synthétiseur permettant de produire un bruit numérique quantifié sur deux niveaux,
- un transducteur,
- une source d'alimentation électrique,
- des moyens de commutation pour connecter la source aux bornes du transducteur,
- des moyens de commande permettant d'actionner les moyens de commutation.

Dans cette forme particulière, les moyens de synthèse produisent, par synthèse numérique itérative sous contrainte de spectre, un bruit binaire, ayant une densité spectrale de puissance déterminée. Le signal de commande appliqué aux moyens de commutation permet de commuter la source aux bornes du transducteur de façon à lui appliquer une tension V lorsque le bruit synthétisé prend un des deux états et une tension -V lorsque le bruit prend l'autre état.

l'invention a également pour objet un procédé de synthèse d'un bruit numérique échantillonné et quantifié sur au moins deux niveaux, ayant une densité spectrale conforme à un gabarit donné caractérisé en ce qu'il comporte au moins:

- une étape d'initialisation durant laquelle le procédé est initialisé à l'aide d'une séquence de bruit échantillonné $x_0(n)$ comportant N échantillons, et d'un filtre gabarit représenté par sa réponse impulsionnelle h(n).

- une première étape de calcul durant laquelle on effectue une opération de filtrage linéaire de $x_0(n)$ par le filtre gabarit h(n) et l'application d'un opérateur non linéaire de quantification Q[.] à la séquence $x_1(n)$ obtenue après filtrage de façon à obtenir une séquence $y_1(n)$ quantifiée suivant le nombre de niveaux désirés.

- une deuxième étape itérative durant laquelle on effectue à chaque itération i:

  - le filtrage de la séquence $y_{i-1}(n)$ par le filtre gabarit h(n)
  - la quantification de la séquence $x_i(n)$ obtenue par filtrage de $y_{i-1}(n)$ de façon à obtenir la séquence quantifiée $y_i(n)$,

  la deuxième étape itérative comportant l'analyse de la densité spectrale de puissance (d.s.p.) de la séquence $y_i$ et le test d'un critère d'adéquation de cette densité spectrale au gabarit désiré, représenté par h(n).

- une étape d'arrêt du procédé, durant laquelle le procédé délivre une séquence x'(n) égale à la séquence $y_i(n)$ obtenue à la dernière itération effectuée, cette étape étant engagée lorsque pour une itération i donnée, le critère d'adéquation est vérifié.

Selon une caractéristique du procédé selon l'invention, le critère d'adéquation, qui peut être choisi en fonction de l'application, est un critère fonction de la distance quadratique moyenne d entre la d.s.p. de la séquence $y_i(n)$ obtenue à l'itération i et le module au carré $\|H(f)\|^2$ de la réponse en fréquence du filtre gabarit h(n).
Selon une autre caractéristique la séquence d'initialisation $x_0(n)$ est une séquence ayant les caractéristiques d'un bruit blanc échantillonné dans la bande du filtre gabarit h(n).
Selon une autre caractéristique la longueur de la séquence de bruit $x_0(n)$ est plus longue que la réponse impulsionnelle h(n). Le procédé de synthèse peut être répété dans le temps de manière glissante moyennant quelques précautions usuelles de traitement du signal pour assurer la continuité des propriétés du bruit obtenu.
Le procédé selon l'invention permet avantageusement de synthétiser un bruit discrétisé ayant une d.s.p. déterminée, et tel que les changements de niveaux soient synchrones d'une horloge fixe de fréquence aussi basse que possible en fonction du gabarit spectral imposé.
Les niveaux de discrétisation peuvent avantageusement être choisis en nombre et en amplitudes permettant ainsi, pour un dispositif de puissance basé sur la mise en série de sources continues, de prendre en compte les caractéristiques des sources pour optimiser leur utilisation dans l'application, visée.
Enfin ce procédé fournissant un bruit numérique de d.s.p. conforme à un gabarit, il est avantageusement possible de corriger les défauts de la réponse du transducteur et de la chaîne d'émission complète pour obtenir en sortie de la transduction la d.s.p. voulue.
Le procédé permettant de synthétiser le bruit à émettre est itératif il est initialisé par une séquence de bruit, laquelle est filtrée par un filtre ayant le gabarit imposé ; à la sortie de ce filtre le signal est discrétisé. Cette double opération de filtrage et discrétisation est réitérée jusqu'à ce qu'une proximité satisfaisante entre la d.s.p. du bruit discrétisé et le gabarit spectral imposé soit obtenu. Cette proximité est testée à chaque itération au sens d'un critère C choisi en fonction de l'application.

## DESCRIPTION DES FIGURES

Les caractéristiques et avantages de l'invention apparaîtront clairement au travers de la description qui suit, description qui s'appuie sur les figures annexées qui représentent:

- la figure 1, un organigramme de principe du procédé selon l'invention, de génération numérique sous contrainte d'un bruit ayant une d.s.p. déterminée et une amplitude qui varie au cours du temps selon un nombre d'états quantifiés,
- la figure 2, le schéma de principe d'un dispositif émetteur selon l'invention, permettant d'émettre un bruit acoustique discrétisé généré à partir du bruit numérique synthétisé à l'aide du procédé selon l'invention,
- la figure 3, le schéma de principe d'un dispositif permettant d'émettre un bruit acoustique généré à partir du bruit numérique synthétisé en utilisant une quantification sur deux niveaux.
- la figure 4, les représentations temporelle et spectrale du signal obtenu par le procédé selon l'invention, dans le cas où l'on applique une quantification sur deux niveaux,

## DESCRIPTION DETAILLEE

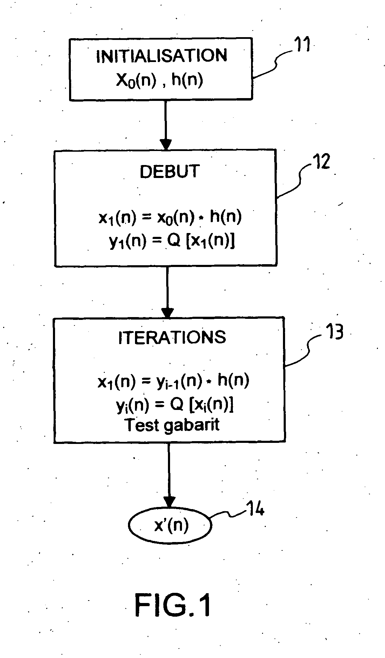

Le processus selon l'invention, illustré par la figure 1, permet de réaliser une synthèse numérique sous contrainte d'un bruit quantifié ayant des caractéristiques spectrales données. Ce bruit synthétisé se présente comme une séquence comportant N échantillons ne pouvant prendre que K valeurs d'amplitude, cadencée par une horloge de période Te = 1/Fe (Fe étant la fréquence de l'horloge)

La fonction générale réalisée par le procédé consiste à produire, à partir d'une séquence de bruit, une séquence de bruit dont la densité spectrale de puissance (d.s.p.) suit un gabarit déterminé. Ce gabarit peut être représenté parle module de la réponse en fréquence H(f) d'un filtre donné.

Comme l'illustre la figure 1 le procédé selon l'invention comporte plusieurs étapes.

**- Initialisation du processus**

Durant cette étape marquée 11 sur la figure 1, le procédé est initialisé à l'aide d'une séquence de bruit échantillonné $x_0(n)$ comportant N échantillons, et d'un filtre gabarit représenté par sa réponse impulsionnelle h(n). Sa réponse en fréquence H(f) a un module au carré, $\|H(f)\|^2$ qui correspond au gabarit de la d.s.p. du bruit désiré.

Selon une variante de mise en oeuvre du procédé selon l'invention, la séquence $x_0(n)$ est une séquence correspondant à un bruit blanc dans la bande couverte par le filtre h(n), l'utilisation du filtre permettant ainsi d'obtenir un bruit "coloré".

**- Entrée dans la bouclé de calculs**

Cette étape 12, comme les itérations suivantes comporte deux opérations : la première opération est une opération de filtrage numérique linéaire de $x_0(n)$ par le filtre gabarit h(n). Cette opération de filtrage numérique est par exemple effectuée soit par transformée de Fourier, soit par convolution circulaire, exprimée par la relation suivante:

$$x_1(n) = x_0(n) * h(n) \qquad [1]$$

La seconde opération consiste en l'application d'un opérateur non linéaire de quantification Q[.] à la séquence $x_1(n)$ obtenue après filtrage. La séquence $y_1(n)$ obtenue après quantification a pour expression générale

$$y_1(n) = Q[x_1(n)] \qquad [2]$$

L'opération de quantification est réalisée au moyen d'un opérateur Q[.] approprié.

Dans le cas où la séquence traitée est une séquence binaire à 2 niveaux 0 et 1, cet opérateur peut par exemple être défini à l'aide de la fonction "signe", noté Sign[.], par la relation suivante:

$$Q[.] = \frac{Sign[.] + 1}{2} \qquad [3]$$

La seule différence entre cette première boucle et les suivantes est que le signal initial $x_0(n)$ auquel est appliqué le filtrage n'est pas quantifié sur K niveaux par l'opérateur Q[.] comme le sont ensuite les signaux nommés y pour les distinguer.

**- Phase itérative**

Durant cette étape 13 d'itérations on effectue de manière itérative les opérations de filtrage et de quantification décrites à l'étape 1. A chaque itération i l'opération de filtrage est appliquée à la séquence $y_{i-1}(n)$ obtenue par quantification lors de l'itération i-1. Cette opération de filtrage de $y_{i-1}(n)$ produit la séquence filtrée $x_i(n)$ à laquelle on applique l'opération de quantification de façon à obtenir la séquence $y_i(n)$.

Durant cette étape pour une itération i donnée on peut écrire les relations suivantes:

$$x_i(n) = y_{i-1}(n) * h(n) \qquad [4]$$

$$y_i(n) = Q[x_i(n)] \qquad\qquad\qquad\qquad [5]$$

Ainsi pour l'itération de rang 2 on aura par exemple :

$$x_2(n) = y_1(n) * h(n) \quad \text{et} \quad y_2(n) = Q[x_2(n)]$$

Si d'autre part on développé l'ensemble des opérations à l'étape i en remontant jusqu'au pseudo bruit blanc original $x_0(n)$, on obtient alors la relation suivante qui caractérise le procédé selon l'invention :

$$y_i(n) = Q[ \underbrace{...Q[ Q[ Q[ x_0(n)}_{i \text{ Quantifications}} \underbrace{* h(n) ] * h(n)] * h(n)] ... * h(n)]}_{i \text{ convolutions}}$$

A la fin de chacune des itérations, des opérations sont effectuées de manière à mesurer la distance séparant la d.s.p. du signal quantifié $y_i(n)$ et le spectre du filtre gabarit h(n). Cette distance est considérée comme une erreur qui doit être minimisée. La similitude de la d.s.p. avec le gabarit choisi est ainsi testée à chaque itération au sens d'un critère C lui-même choisi en fonction de l'application.

L'étape itérative est interrompue lorsqu'un critère d'arrêt est vérifié. Ce critère peut prendre diverses formes, ce sera par exemple le passage en dessous d'un seuil d'une distance quadratique moyenne entre le gabarit et la d.s.p. du signal $y_i(n)$.

Le procédé fournit alors à l'utilisation une séquence numérique de sortie x'(n) 14, échantillonnée à la fréquence $F_e = 1/T_e$. La séquence x'(n) correspond à la séquence $y_i(n)$ obtenue lors de la dernière itération effectuée.

Il est à noter que, comme durant la phase itérative, le procédé selon l'invention peut procéder à la fin de la phase d'entrée dans la boucle de calculs à des opérations visant à mesurer la distance séparant la d.s.p. du signal quantifié $y_i(n)$ et le spectre du filtre gabarit h(n). Si le critère d'arrêt C est vérifié le procédé est interrompu à ce stade et un signal $x'(n) = y_1(n)$ est alors délivré.

Le procédé selon l'invention présente l'avantage de permettre d'obtenir de manière simple un signal quantifié et échantillonné selon un nombre déterminé de niveaux et dont les variations de niveau au cours du temps sont synchrones de l'horloge de base Te.

Le signal ainsi réalisé peut, en outre, être avantageusement conformé de façon à être utilisé pour commander la mise en oeuvre de dispositifs simples,

peu encombrants et à haut rendement, permettant de générer un signal électrique de forte amplitude, destiné à exciter un transducteur, un transducteur acoustique par exemple, de façon à ce qu'il émette une onde ayant les caractéristiques désirées.

La caractéristique avantageuse du procédé, qui permet en respectant les contraintes spectrales de réaliser les changements de niveaux de manière synchrone d'une horloge, limite les pertes de commutation qui se produiraient en cas de succession rapide de changements de niveau.

Le procédé permettant de synthétiser le bruit à émettre est itératif, il est initialisé par une séquence de bruit, laquelle est filtrée par un filtre ayant le gabarit imposé ; à la sortie de ce filtre le signal est discrétisé. Cette double opération de filtrage et discrétisation est réitérée jusqu'à ce qu'une proximité satisfaisante entre la d.s.p. du bruit discrétisé et le gabarit spectral imposé soit obtenu ; cette proximité est testée à chaque itération au sens d'un critère C choisi en fonction de l'application.

Selon une forme préférée de mise en oeuvre le critère C est basé sur la mesure de la distance quadratique moyenne d entre la d.s.p. du bruit discrétisé et le module au carré de la réponse en fréquence du filtre gabarit.

Le procédé selon l'invention permet ainsi de créer une séquence de bruit de longueur finie qu'il est possible de répéter de façon à obtenir l'émission d'un bruit de durée désirée. Selon une forme préférée de mise en oeuvre la séquence de bruit blanc $x_0(n)$ utilisée lors de l'étape d'initialisation est sensiblement plus longue que la réponse impulsionnelle du filtre gabarit. Le procédé de synthèse peut être répété dans le temps de manière glissante, en fin de séquence de filtrage de $x_0(n)$ un recouvrement entre la précédente séquence d'initialisation $x_0(n)$ et la nouvelle séquence d'initialisation sensiblement égal au support de la réponse percussionnelle du filtre gabarit de façon à assurer la continuité de la séquence créée en évitant des transitoires selon des techniques connues en traitement de signal.

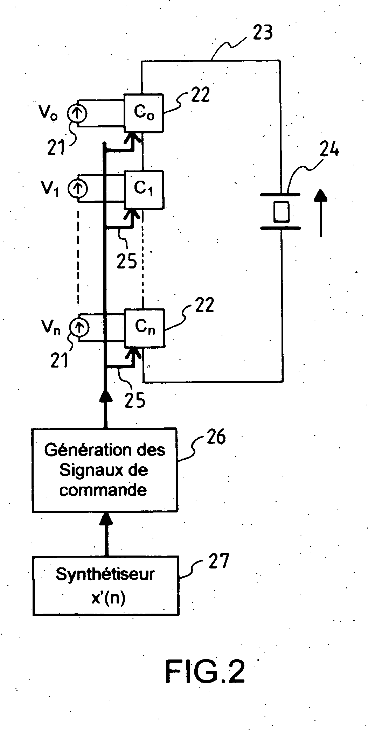

On s'intéresse à présent à la figure 2 qui présente le schéma de principe du dispositif de puissance selon l'invention, permettant d'exciter un transducteur pour émettre un bruit analogique discrétisé (sur K niveaux d'amplitude) qui est, en terme de traitement du signal, le signal interpolé d'ordre zéro de la séquence de bruit échantillonné et quantifiée (sur K niveaux) obtenue en sortie du processus itératif décrit précédemment. Comme on peut le constater sur la figure 2, un tel dispositif possède une structure très simple constitué de sources de tension 21 ($v_0$ ... $v_n$) non référencées les unes par rapport aux autres et dont les valeurs sont identiques ou différentes selon l'application envisagée en particulier selon les niveaux de quantification choisis.

L'utilisation de sources identiques présente l'avantage de permettre une gestion intelligente de sources telles que des piles ou des batteries utilisées en veillant à une utilisation, et donc à une décharge, équilibrée de ces sources qui, dans la mesure où elles sont identiques, sont interchangeables. Ce mode de gestion s'avère particulièrement avantageux pour les dispositifs d'émission montés sur des véhicules autonomes et pour tous les systèmes ayant des contraintes d'autonomie.

L'utilisation de sources ayant des niveaux différents permet, quant à elle, de multiplier les niveaux de discrétisation du signal sans pour autant multiplier le nombre des sources ce qui peut présenter un avantage en terme de poids et d'encombrement. Ainsi, avec deux sources V1 et V2, on peut réaliser V1, V2, V2-V1,-V1+V2, -V1, -V2, V1-V2, -V1-V2.

Il est en outre possible de modifier la structure de base de la figure 2 de façon à constituer un dispositif un peu plus complexe, non illustrée, constitué de sources intermédiaires, consistant en des piles ou des batteries par exemple, fournissant la puissance nécessaire sous les meilleures conditions de tension et de courant pour réaliser l'excitation du transducteur 24, ces sources étant suivies d'un dispositif à découpage (hacheurs) destiné à élever la tension fournie au niveau nécessaire pour le transducteur. On introduit ainsi un degré de liberté qui permet une optimisation de la décharge des piles ou batteries pour tenir compte de leurs caractéristiques de capacité. Selon la configuration souhaitée, le dispositif à découpage peut être installé derrière le circuit de mise en série des sources. Ce dispositif peut encore être constitué d'un ensemble de dispositifs à découpage, un dispositif étant placé aux bornes de chaque source avant le circuit de mise en série.

Quel que soit le type de réalisation envisagé du dispositif selon l'invention, les sources de tension $v_0$ ... $v_n$ utilisées sont intégrées au circuit série 23 par l'intermédiaire d'éléments de commutation 21. les bornes du circuit 23 sont quant à elles reliées aux électrodes du transducteur 24.

Chacune des sources de tension 21 est associée à un dispositif de commutation 22 dont le rôle consiste à autoriser ou non l'intégration de la source dans le circuit série 23 d'alimentation du transducteur 24. Chaque dispositif de commutation 22 est commandé par un signal 25 généré par des moyens de synthèse 26. Chaque commande prend au cours du temps une valeur qui est fonction du signal x'(n) synthétisé par le procédé selon l'invention illustré par la figure 1, et synchrone de celui-ci. L'ensemble des signaux de commande constitue une séquence temporelle définie de façon à ce que le signal appliqué par le circuit série au transducteur constitue un signal discrétisé dont la densité spectrale de puissance soit conforme au gabarit défini.

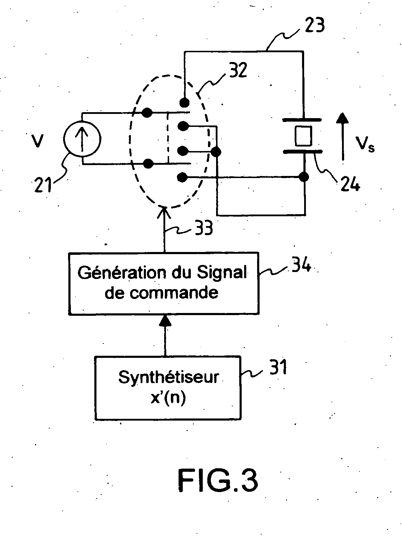

Dans un mode de réalisation simple, donné à titre d'exemple et illustré par la figure 3, le dispositif selon l'invention peut consister en une seule source de tension 21 associée à un dispositif inverseur 32 permettant d'appliquer au transducteur soit une tension +V, soit une tension -V. Dans cet exemple simple le signal de commande 31 appliqué à l'inverseur peut être directement un signal x'(n) codé sur un bit et synthétisé par le procédé décrit précédemment

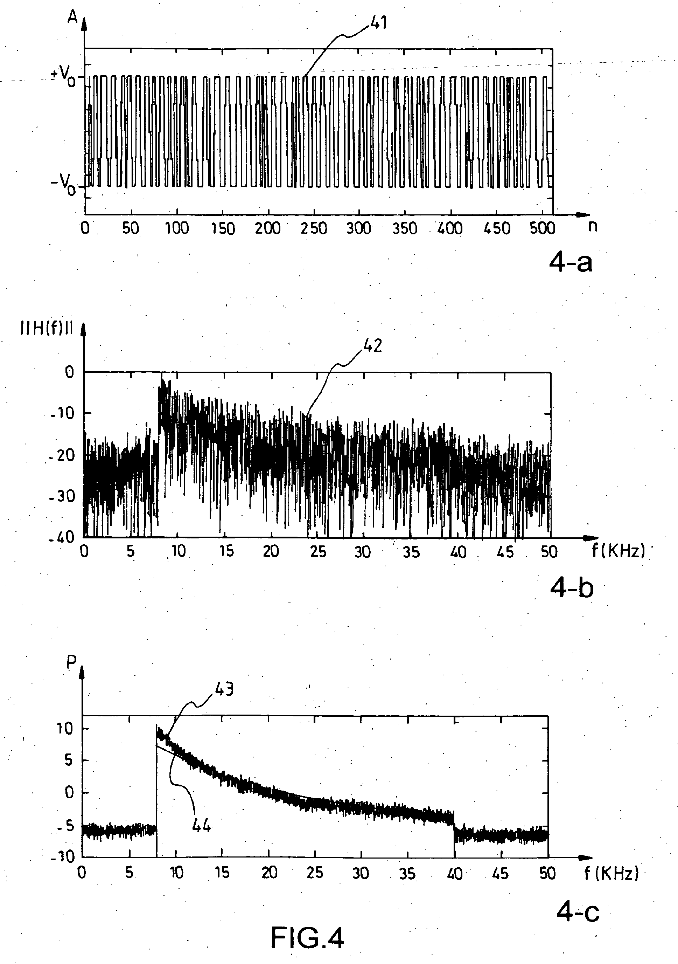

On s'intéresse ensuite à la figure 4 qui illustre un exemple de mise en oeuvre du procédé selon l'invention. Dans cet exemple le bruit synthétisé est un bruit coloré simulant du bruit de mer dont la densité spectrale de puissance suit sensiblement une loi en -17log(f) entre 8kHz et 40kHz.

Le filtre utilisé ici a une fonction de transfert H(f) d'amplitude nulle pour les fréquences inférieures à 8 kHz et supérieures à 40 kHz, et dont l'amplitude suit une loi de variation en -17log(f) entre 8kHz et 40kHz. Le bruit est en outre synthétisé sous forme d'une séquence de 512 échantillons temporels x'(n) codés sur deux états (codage sur 1 bit). La séquence est cadencée par une horloge unique à pas constant Te.

La figure 4-a représente la courbe 41 de variation d'amplitude d'une suite x'(n) de 512 échantillons obtenus après mise en oeuvre du procédé selon l'invention. Le signal x'(n) se présente ainsi sous la forme d'une simple séquence binaire chaque échantillon ne pouvant prendre qu'une des deux valeurs alternatives $-V_0$ ou $V_0$.

La figure 4-b quant à elle représente la courbe 42 de densité spectrale de puissance du signal x'(n) obtenu par le procédé selon l'invention.

La figure 4-c représente simultanément la valeur moyenne 43 du spectre de x'(n) représenté par la courbe sur la figure 4-b et le module 44 de la fonction de transfert du filtre H(f). Elle permet de constater que le procédé selon l'invention permet de restituer de manière simple un signal ayant un gabarit fréquentiel donné, un bruit de mer en l'occurrence, à partir d'une simple séquence binaire, la suite x'(n) étant alors constitué d'échantillons codés sur 1. bit (2niveaux). La densité spectrale obtenue suit sensiblement le gabarit souhaité avec une pente d'évolution dans la bande utile sensiblement égale à -17log(f).

L'exemple de mise en oeuvre illustré par la figure 4 permet de vérifier que le procédé selon l'invention permet d'obtenir le signal désiré à moindre coût. En effet l'amplification d'un signal constitué d'une séquence binaire nécessite seulement l'emploi d'une source de tension continue V et d'un dispositif de commutation permettant d'appliquer sur le transducteur, selon l'état du bit constituant le signal x'(n), une tension égale soit à +V soit à -V.

**Revendications**

1. Dispositif pour l'émission d'un bruit discrétisé sur au moins deux niveaux, comportant au moins:

- un synthétiseur (27) permettant de produire un bruit numérique échantillonné et quantifié,
- un transducteur (24) relié à un circuit d'alimentation (23),
- des sources d'alimentation électrique (21),
- des commutateurs (22) pour intégrer séparément chaque source au circuit d'alimentation, les sources intégrées au circuit d'alimentation étant mises en série les unes avec les autres,
- des moyens de commande (26) permettant de générer les signaux de commande (25) de chaque commutateur,

**caractérisé en ce que**, le synthétiseur (27) produisant, par synthèse numérique itérative sous contrainte de spectre, une séquence de bruit x'(n) discrétisée ayant une densité spectrale de puissance déterminée, le signal de commande (25) appliqué à chaque commutateur est généré par les moyens de commande (26) en fonction de la séquence de bruit x'(n) produite par le synthétiseur (27), le signal de commande (25) étant synchrone de l'horloge de base du synthétiseur, un certain nombre de sources étant mises en série, à un instant t, aux bornes du transducteur, ce nombre étant fonction de la valeur à cet instant de la séquence de bruit produite par le synthétiseur.

2. Dispositif d'émission selon la revendication 1 dans lequel pour chaque valeur de tension à appliquer au transducteur, les moyens de commande (26) produisent un signal de commande (25) qui est fonction de la valeur du bruit produit par le synthétiseur et des caractéristiques de chacune des sources 21) disponibles.

3. Dispositif d'émission selon l'une des revendications 1 à 2 comportant L sources (21) identiques et des moyens de commandes (26) adaptés pour gérer la mise en service de chaque source en fonction de la tension à appliquer à l'instant considéré et du taux d'utilisation de chaque source (21) à cet instant.

4. Dispositif pour l'émission d'un bruit discrétisé, comportant au moins:

- un synthétiseur (31) permettant de produire un bruit numérique discrétisé,
- un transducteur,
- une source d'alimentation électrique (21),
- des moyens de commutation (32) pour connecter la source aux bornes du transducteur (24),
- des moyens de commande (34) permettant d'actionner les moyens de commutation,

**caractérisé en ce que**, le synthétiseur (31) produisant, par synthèse numérique itérative sous contrainte de spectre, une séquence binaire de bruit x'(n), discrétisée sur 2 états, ayant une densité spectrale de puissance déterminée, le signal de commande (33) appliqué à aux moyens de commutation permet de commuter la source aux bornes du transducteur de façon à lui appliquer une tension V lorsque le bruit synthétisé prend un des deux états et une tension -v lorsque le bruit prend l'autre état.

5. Procédé pour synthétiser une séquence de bruit numérique quantifiée sur K niveaux x'(n), ayant une densité spectrale conforme à un gabarit donné **caractérisé en ce qu'**il comporte au moins :

- une étape d'initialisation (11) durant laquelle le procédé est initialisé à l'aide d'une séquence de bruit échantillonné $x_0(n)$ comportant N échantillons, et d'un gabarit de filtre représenté par sa réponse impulsionnelle h(n).
- une première étape (12) de calcul durant laquelle on effectue une opération de filtrage linéaire de $x_0(n)$ par le filtre gabarit h(n) et l'application d'un opérateur non linéaire de quantification Q[.] à la séquence $x_1(n)$ obtenue après filtrage de façon à obtenir une séquence quantifiée $y_1(n)$.
- une deuxième étape itérative (13) durant laquelle on effectue à chaque itération i :

- le filtrage de la séquence $y_{i-1}(n)$ par le filtre gabarit h(n)
- la quantification de la séquence $x_i(n)$ obtenue par filtrage de $y_{i-1}(n)$ de façon à obtenir la séquence quantifiée

$y_i(n)$,

la deuxième étape itérative (13) comportant l'analyse de la densité spectrale de puissance (d.s.p.) de la séquence $y_i$ obtenue et le test d'un critère d'adéquation de cette densité spectrale au gabarit désiré, représenté par h(n).
- une étape d'arrêt du procédé (14), durant laquelle le procédé délivre une séquence x'(n) égale à la séquence $y_i(n)$ obtenue à la dernière itération effectuée, cette étape étant engagée lorsque pour une itération i donnée, le critère d'adéquation est vérifié.

6. Procédé selon la revendication 5 dans lequel le critère d'adéquation est un critère fonction de la distance quadratique moyenne d entre la d.s.p. de la séquence $y_i(n)$ obtenue à l'itération i et le module au carré $\|IH(f)\|^2$ de la réponse en fréquence du filtre gabarit.

7. Procédé selon l'une quelconque des revendications 5 ou 6, dans lequel la séquence d'initialisation $x_0(n)$ est une séquence ayant les caractéristiques d'un bruit blanc échantillonné dans la bande du filtre de gabarit h(n).

8. Procédé selon l'une quelconque des revendications 5 à 7, dans lequel la longueur de la séquence de bruit $x_0(n)$ est plus longue que la réponse impulsionnelle h(n), le procédé de synthèse prouvant être répété dans le temps de manière glissante, avec en fin de séquence $x_0(n)$ un recouvrement entre la précédente séquence d'initialisation et la nouvelle séquence d'initialisation sensiblement égal au support de la réponse percussionnelle du filtre gabarit de façon à assurer la continuité de la séquence créée en évitant des transitoires.

## Claims

1. Device for transmitting a discretized noise on at least two levels, comprising at least:

    - a synthesizer (27) for producing a sampled and quantized digital noise,
    - a transducer (24) linked to a power supply circuit (23),
    - electrical power supply sources (21),
    - switches (22) for separately incorporating each source in the power supply circuit, the sources incorporated in the power supply circuit being placed in series with one another,
    - control means (26) for generating the control signals (25) for each switch,

    **characterized in that**, the synthesizer (27) producing, by iterative digital synthesis under spectral constraint, a discretized noise sequence x'(n) having a determined power spectral density, the control signal (25) applied to each switch is generated by the control means (26) according to the noise sequence x'(n) produced by the synthesizer (27), the control signal (25) being synchronous with the basic clock of the synthesizer, a certain number of sources being placed in series, at a time t, with the terminals of the transducer, this number being a function of the value at this time of the noise sequence produced by the synthesizer.

2. Transmission device according to Claim 1, in which, for each voltage value to be applied to the transducer, the control means (26) produce a control signal (25) which is a function of the value of the noise produced by the synthesizer and of the characteristics of each of the available sources (21).

3. Transmission device according to either of Claims 1 and 2, comprising L identical sources (21) and control means (26) suitable for managing the enabling of each source according to the voltage to be applied at the time concerned and the usage rate of each source (21) at that time.

4. Device for transmitting a discretized noise, comprising at least:

    - a synthesizer (31) for producing a discretized digital noise,
    - a transducer,
    - an electrical power supply source (21),
    - switching means (32) for connecting the source to the terminals of the transducer (24),
    - control means (34) for actuating the switching means,

    **characterized in that**, the synthesizer (31) producing, by iterative digital synthesis under spectral constraint, a binary noise sequence x'(n), discretized on two states, having a determined power spectral density, the control signal (33) applied to the switching means makes it possible to switch the source to the terminals of the transducer so as to apply to it a voltage V when the synthesized noise assumes one of the two states and a voltage -v when the noise assumes the other state.

5. Method for synthesizing a digital noise sequence quantized on K levels x'(n), having a spectral density conforming to a given mask **characterized in that** it comprises at least:

- an initialization step (11) during which the method is initialized using a sampled noise sequence $x_0(n)$ comprising N samples, and a filter mask represented by its impulse response h(n).
- a first computation step (12) during which an $x_0(n)$ linear filtering operation is performed by the mask filter h(n) and a nonlinear quantization operator Q[.] is applied to the sequence $x_1(n)$ obtained after filtering so as to obtain a quantized sequence $y_1(n)$.
- a second iterative step (13) during which, on each iteration i, the following are performed:

    - the filtering of the sequence $y_{i-1}(n)$ by the mask filter h(n)
    - the quantization of the sequence $x_i(n)$ obtained by filtering $y_{i-1}(n)$ so as to obtain the quantized sequence $y_i(n)$,

the second iterative step (13) comprising the analysis of the power spectral density (p.s.d.) of the sequence $y_i$ obtained and the test of a criterion of adequacy of this spectral density to the desired mask, represented by h(n).
- a step for stopping the method (14), during which the method delivers a sequence x'(n) equal to the sequence $y_i(n)$ obtained on the last iteration carried out, this step being undertaken when, for a given iteration i, the adequacy criterion is satisfied.

6. Method according to Claim 5, in which the adequacy criterion is a criterion dependent on the mean quadratic distance d between the p.s.d. of the sequence $y_i(n)$ obtained on the iteration i and the modulus squared $\|H(F)\|^2$ of the frequency response of the mask filter.

7. Method according to either of Claims 5 and 6, in which the initialization sequence $x_0(n)$ is a sequence having the characteristics of a sampled white noise in the band of the mask filter h(n).

8. Method according to any one of Claims 5 to 7, in which the length of the noise sequence $x_0(n)$ is longer than the impulse response h(n), the synthesis method being able to be repeated in time in a rolling manner, with, at the end of the sequence $x_0(n)$, an overlap between the preceding initialization sequence and the new initialization sequence that is roughly equal to the carrier of percussive response of the mask filter so as to ensure the continuity of the sequence created by avoiding transients.

**Patentansprüche**

1. Vorrichtung zum Aussenden eines diskretisierten Rauschens auf wenigstens zwei Ebenen, die wenigstens enthält:

- einen Synthetisierer (27), der ermöglicht, ein abgetastetes und quantifiziertes digitales Rauschen zu erzeugen,
- einen Wandler (24), der mit einer Versorgungsschaltung (23) verbunden ist,
- Stromversorgungsquellen (21),
- Schalter (22), um jede Quelle getrennt in die Versorgungsschaltung zu integrieren, wobei die in die Versorgungsschaltung integrierten Quellen zueinander in Reihe geschaltet sind,
- Steuermittel (26), die ermöglichen, Steuersignale (25) jedes Schalters zu erzeugen,

**dadurch gekennzeichnet, dass** der Synthetisierer (27) durch iterative digitale Synthese unter Spektrumsbeschränkung eine diskretisierte Rauschsequenz x'(n) erzeugt, die eine bestimmte Leistungsspektraldichte besitzt, wobei das in jeden Schalter eingegebene Steuersignal (25) durch die Steuermittel (26) als Funktion der durch den Synthetisierer (27) erzeugten Rauschsequenz x'(n) erzeugt wird, wobei das Steuersignal (25) zu dem Basistakt des Synthetisierers synchron ist, wobei zu einem Zeitpunkt t eine bestimmte Anzahl von Quellen zu den Anschlüssen des Wandlers in Reihe geschaltet wird, wobei diese Anzahl von dem Wert zu diesem Zeitpunkt der durch den Synthetisierer erzeugten Rauschsequenz abhängt.

2. Aussendevorrichtung nach Anspruch 1, bei der die Steuermittel (26) für jeden an den Wandler anzulegenden Spannungswert ein Steuersignal (25) erzeugen, das von dem Wert des durch den Synthetisierer erzeugten Rauschens und von den Eigenschaften jeder der verfügbaren Quellen (21) abhängt.

3. Aussendevorrichtung nach einem der Ansprüche 1 bis 2, die L gleiche Quellen (21) sowie Steuermittel (26) enthält, die dazu ausgelegt sind, die Inbetriebnahme jeder Quelle in Abhängigkeit von der Spannung, die zu diesem betrachteten Zeitpunkt anzulegen ist, und von dem Nutzungsanteil jeder Quelle (21) zu diesem Zeitpunkt zu steuern.

4. Vorrichtung zum Aussenden eines diskretisierten Rauschens, die wenigstens enthält:

    - einen Synthetisierer (31), der ermöglicht, ein diskretisiertes digitales Rauschen zu erzeugen,
    - einen Wandler,
    - eine Stromversorgungsquelle (21),
    - Schaltermittel (32), um die Quelle mit den Anschlüssen des Wandlers (24) zu verbinden,
    - Steuermittel (34), die ermöglichen, die Schaltermittel zu betätigen,

**dadurch gekennzeichnet, dass** dann, wenn der Synthetisierer (31) durch iterative digitale Synthese unter Spektrumsbeschränkung eine binäre Rauschsequenz x'(n), die auf 2 Zustände diskretisiert ist und eine bestimmte Leistungsspektraldichte besitzt, erzeugt, das in die Schaltermittel eingegebene Steuersignal (33) ermöglicht, die Quelle zu den Anschlüssen des Wandlers in der Weise zu schalten, dass an sie eine Spannung V angelegt wird, wenn das synthetisierte Rauschen einen der zwei Zustände annimmt, und dass an sie eine Spannung -v angelegt wird, wenn das Rauschen den anderen Zustand annimmt.

5. Verfahren zum Synthetisieren einer quantifizierten digitalen Rauschsequenz x'(n) auf K Ebenen, die eine Spektraldichte gemäß einer gegebenen Schablone besitzt, **dadurch gekennzeichnet, dass** es wenigstens enthält:

    - einen Initialisierungsschritt (11), in dem das Verfahren mit Hilfe einer Sequenz $x_0(n)$ abgetasteten Rauschens, die N Abtastwerte enthält, und einer Filterschablone, die durch ihre Impulsantwort h(n) repräsentiert wird, initialisiert wird,
    - einen ersten Berechnungsschritt (12), in dem eine lineare Filterungsoperation von $x_0(n)$ durch das Schablonenfilter h(n) und die Anwendung eines nichtlinearen Quantifizierungsoperators Q[.] auf die nach der Filterung erhaltene Sequenz $x_1(n)$ ausgeführt wird, derart, dass eine quantifizierte Sequenz $y_1(n)$ erhalten wird,
    - einen zweiten iterativen Schritt (13), in dem bei jeder Iteration i ausgeführt wird:

        - die Filterung der Sequenz $y_{i+1}(n)$ durch das Schablonenfilter h(n),
        - die Quantifizierung der Sequenz $x_i(n)$, die durch Filtern von $y_{i-1}(n)$ erhalten wird, derart, dass eine quantifizierte Sequenz $y_i(n)$ erhalten wird,

    wobei der zweite iterative Schritt (13) die Analyse der Leistungsspektraldichte (dsp) der erhaltenen Sequenz $y_i$ und den Test eines Adäquatheitskriteriums dieser Spektraldichte bezüglich der gewünschten Schablone, die durch h(n) repräsentiert wird, enthält,
    - einen Schritt des Anhaltens des Verfahrens (14), in dem das Verfahren eine Sequenz x'(n) liefert, die gleich der in der letzten ausgeführten Iteration erhaltenen Sequenz $y_i(n)$ ist, wobei dieser Schritt ausgeführt wird, wenn für eine gegebene Iteration i das Adäquatheitskriterium verifiziert wird.

6. Verfahren nach Anspruch 5, wobei das Adäquatsheitkriterium ein Kriterium ist, das vom mittleren quadratischen Abstand d zwischen dsp der bei der Iteration i erhaltenen Sequenz $y_i(n)$ und dem Betrag zum Quadrat $\|H(f)\|^2$ der Frequenzantwort des Schablonenfilters abhängt.

7. Verfahren nach einem der Ansprüche 5 oder 6, wobei die Intitialisierungssequenz $x_0(n)$ eine Sequenz ist, die die Charakteristiken eines abgetasteten weißen Rauschens im Band des Schablonenfilters h(n) besitzt.

8. Verfahren nach einem der Ansprüche 5 bis 7, wobei die Länge der Rauschsequenz $x_0(n)$ länger als die Impulsantwort h(n) ist, wobei das Syntheseverfahren in der Zeit gleitend wiederholt werden kann, wobei am Ende der Sequenz $x_0(n)$ eine Abdeckung zwischen der vorhergehenden Initialisierungssequenz und der neuen Initialisierungssequenz besteht, die im Wesentlichen gleich dem Träger der Rückantwort des Schablonenfilters ist, derart, dass die Kontinuität der erzeugten Sequenz unter Vermeidung von Übergängen sichergestellt ist.

FIG.1

FIG.2

FIG.3

4-a

4-b

4-c

FIG.4

**EP 1 913 693 B1**